# EUROPEAN PATENT SPECIFICATION

(11) **EP 4 539 109 B1**
(45) Date of publication and mention of the grant of the patent: **17.06.2026**
(21) Application number: 24201047.8
(22) Date of filing: 18.09.2024
(51) Int. Cl.: H10W 99/00, H10W 70/60, H10W 70/68, H10W 70/69, H10W 70/05, H05K 3/46, H05K 1/02, H10W 70/63, H10W 70/685, H10W 70/692, H05K 1/03

(54) **MANUFACTURING METHOD OF PACKAGING SUBSTRATE AND PACKAGING SUBSTRATE USING THE SAME**
HERSTELLUNGSVERFAHREN FÜR EIN VERPACKUNGSSUBSTRAT UND VERPACKUNGSSUBSTRAT DAMIT
PROCÉDÉ DE FABRICATION D'UN SUBSTRAT D'ENCAPSULATION ET SUBSTRAT D'ENCAPSULATION L'UTILISANT

(30) Priority: 12.10.2023 US 202363543734 P
(43) Date of publication of application: 16.04.2025
(73) Proprietor: Absolics Inc., Covington, GA 30014 (US)
(72) Inventor: LIM, Chaemook, Covington, Georgia, 30014 (US)
(74) Representative: BCKIP Part mbB

(56) References cited:
- US-A1- 2012 189 818
- US-A1- 2014 166 348
- US-A1- 2019 259 696
- US-A1- 2020 176 405
- BOURAS N ET AL: "Thermal and mechanical characterization of borosilicate glass", PHYSICS PROCEDIA, ELSEVIER, AMSTERDAM, NL, vol. 2, no. 3, 1 November 2009 (2009-11-01), pages 1135 - 1140, XP026868920, ISSN: 1875-3892, [retrieved on 20091101]

## Description

### CROSS-REFERENCE TO RELATED APPLICATION

This application claims the priority benefit of U.S. provisional application serial no. 63/543,734, filed on October 12, 2023.

### BACKGROUND

### Technical Field

The following description relates to a substrate for packaging, a semiconductor package, a method for manufacturing a substrate for packaging, and a method for manufacturing a semiconductor package.

### Description of Related Art

When manufacturing an electronic component, implementing the circuitry on a semiconductor wafer is called the Front-End (FE), and assembling the wafer into a product-ready state is called the Back-End (BE). The latter includes the packaging process.

The four core technologies of the semiconductor industry that have enabled the rapid development of electronic products in recent years are semiconductor technology, semiconductor packaging technology, manufacturing process technology, and software technology.

Semiconductor technology is advancing in many ways, including sub-micron to nanoscale linewidths, 10 million or more cells, high-speed operation, and lots of heat dissipation, but the technology to package devices perfectly is still required for more progress now.

Therefore, the electrical performance of a semiconductor is often determined by the packaging technology and its electrical connections rather than the performance of the semiconductor technology itself.

A substrate for packaging may be made of ceramic or resin. The ceramic substrate, such as a silicon substrate, has high resistivity or high dielectric constant, making it difficult to mount high-performance, high-frequency semiconductor devices. In the case of resin substrates, it is possible to mount relatively high-performance, high-frequency semiconductor devices. However, there are limitations in reducing the pitch of the wiring.

Recently, a silicon substrate or a glass substrate may be used as a substrate for high-end packaging. By forming through-holes in the silicon or glass substrate and applying conductive materials to the through-holes, the wiring between the device and the motherboard can be shortened and have good electrical characteristics.

In addition, the semiconductor package may generate heat during operation and may further include heat dissipation means for dissipating such heat.

### SUMMARY

The present disclosure is directed to a method of manufacturing a device package and a packaging substrate using the same.

A packaging substrate according to the present disclosure includes a core layer and an upper layer disposed on the core layer. The core layer comprises a glass core having a first face and a second face facing each other. The upper layer comprises a first distribution layer formed on the core layer, and a dummy layer formed on the first distribution layer. The dummy layer comprises a material having a lower Coefficient of Thermal Expansion (CTE) than a CTE of an insulating material of the first distribution layer. As e.g. exemplified in US 2020/176405 A1, US 2012/189818 A1, US 2014/166348 A1, and US 2019/259696 A1.

The upper layer further include includes a second distribution layer formed on the dummy layer. The dummy layer may be disposed between the first distribution layer and the second distribution layer and may directly abut the first distribution layer.

When the difference (absolute value) between a CTE of the glass core and a CTE of the first distribution layer is called D_C, and the difference (absolute value) between the CTE of the first distribution layer and a CTE of the dummy layer is called D_D, the D_D is a value less than the D_C.

The dummy layer may include 80 wt% of inorganic material.

The dummy layer may be an inorganic layer.

The dummy layer may include polycrystalline silicon, SiO2 or a metal layer.

The CTE of the dummy layer may be 20 ppm/°C or less.

The upper layer may further include a fine distribution layer on the second distribution layer. The second distribution layer includes a polymeric resin A and an inorganic particle A, and the fine distribution layer includes a polymeric resin B and an inorganic particle B. An average size of the inorganic particle A may be smaller than an average size of the inorganic particle B.

The packaging substrate may further include a lower layer disposed below the core layer.

The lower layer may include a third distribution layer formed under the core layer; a lower dummy layer formed under the third distribution layer; and a fourth distribution layer formed under the lower dummy layer.

A method of manufacturing a packaging substrate according to present disclosure includes: preparing a core layer comprising a glass core; forming a first distribution layer by disposing a first insulating material, a first conductive pattern, or a combination thereof on the core layer; and forming a dummy layer on the first distribution layer. The dummy layer includes a material having a lower CTE than a CTE of the first insulating material.

The method of manufacturing the packaging substrate further includes forming a second distribution layer by disposing a second insulating material, a second conductive pattern, or a combination thereof on the dummy layer. A CTE of the dummy layer is less than a CTE of the second insulating material.

The method of manufacturing the packaging substrate may further include forming a third distribution layer by disposing the third insulating material and the third conductive pattern under the core layer. The dummy layer may include a material having a lower CTE than a CTE of the third insulating material.

The method of manufacturing the packaging substrate may further include: forming a third distribution layer by disposing the third insulating material and the third conductive pattern under the core layer; forming a lower dummy layer under the third distribution layer; and forming a fourth distribution layer by disposing the fourth insulating material and the fourth conductive pattern under the lower dummy layer.

### BRIEF DESCRIPTION OF THE DRAWINGS

FIG. 1 is a conceptual diagram illustrating a cross-sectional structure of a packaging substrate, according to an embodiment.
FIG. 2 is a conceptual diagram illustrating a cross-sectional structure of a packaging substrate, according to another embodiment.
FIG. 3A and FIG. 3B are conceptual diagrams illustrating a cross-sectional view of a portion of a packaging substrate, according to an embodiment, respectively.
FIG. 4 is a cross-sectional flowchart illustrating a process for preparing a core distribution layer in manufacturing of a packaging substrate, according to an embodiment.
FIG. 5 is a cross-sectional flowchart illustrating a process for preparing an insulating layer in manufacturing of a packaging substrate, according to an embodiment.
FIGs. 6A through 6C are conceptual cross-sectional diagrams illustrating problems encountered during heat treatment of a packaging substrate comprising a core layer and a plurality of distribution layers, respectively.
FIGs. 7A through 7C are conceptual diagrams illustrating, in cross-section, a heat treatment process for a packaging substrate comprising a dummy layer formed between distribution layers, according to embodiments.

### DESCRIPTION OF THE EMBODIMENTS

In order to provide a comprehensive understanding of the methods, apparatus, and/or systems described herein, the following detailed description is provided. However, various modifications, adaptations, and equivalents of the methods, devices, and/or systems described herein will become apparent after understanding what this disclosure presents. For example, the sequence of operations described herein is by way of example only and is not intended to be limiting to the operations described herein. With the exception of steps that are not necessarily performed in a particular order, the order of operations may be altered based on an understanding of what is disclosed herein. Further, descriptions of features already known in the art may be omitted for clarity and brevity after understanding the disclosure of this application. However, the omission of such features and their descriptions is not intended to be recognized as general knowledge.

The features described herein may be implemented in different forms and are not to be construed as being limited to the examples described herein. Rather, the embodiments described herein are provided to illustrate some of the many possible ways of implementing the methods, devices, and/or systems described herein that will become apparent after understanding the disclosures of this application.

The terms "first," "second," "third," and the like may be used herein to describe various members, components, regions, layers, or sections, but are not intended to limit the members, components, regions, layers, or sections to these words. Instead, these terms are used for the purpose of distinguishing one member, component, region, layer, or section from another member, component, region, layer, or section. Thus, a first member, component, region, layer, or section referred to in the embodiments described herein may also be referred to as a second member, component, region, layer, or section without departing from the teachings of the embodiments.

Throughout the specification, when an element, such as a layer, region, or substrate, is described as being "on," "connected to," or "coupled to" another element, it may be described as being directly "on," "connected to," or "coupled to" the other element, or it may have one or more other elements interposed between them. In contrast, when an element is described as "directly on", "directly connected to", or "directly joined to" another element, no other element can intervene between them. Similarly, for example, expressions such as "between" and "directly between," and "abutting" and "directly abutting" can also be interpreted as described above.

The terms used in this specification are intended to describe specific examples and are not intended to limit the disclosure. The singular form used herein is intended to include the plural form unless the context clearly indicates otherwise. As used herein, the term "and/or" includes any one or a combination of two or more of the relevant list items. The terms "comprising," "consisting of," and "having" as used herein specify the presence of the specified features, numbers, actions, elements, components, and/or combinations thereof, but do not exclude the presence or addition of one or more other features, numbers, actions, elements, components, and/or combinations thereof. The use of the term "may" in this specification with respect to an example or embodiment (e.g., with respect to what an example or embodiment may include or implement) implies that there is at least one example or embodiment that includes or implements such features, but that not all examples are limited thereto.

In this specification, "B being located on A" means that B is disposed on top of A, either in direct contact with A or with another layer or structure interposed therebetween, and should not be construed to mean that B is necessarily in direct contact with A only.

Unless otherwise defined, all terms used herein shall have the same meaning as commonly understood by those of ordinary skill in the art to which the following description belongs. Terms such as those defined in commonly used dictionaries are to be construed to have meanings consistent with their meaning in the context of the prior art and the following description and are not to be construed in an idealized or overly formal sense unless expressly defined herein.

In one or more of the examples above, a description of "A and/or B" means "A, B, or A and B".

In one or more of the above examples, terms such as "first," "second," "A," or "B" are used to distinguish similar terms from each other.

In one or more of the above examples, a singular form may be contextually interpreted to include the plural as well as the singular, unless otherwise noted.

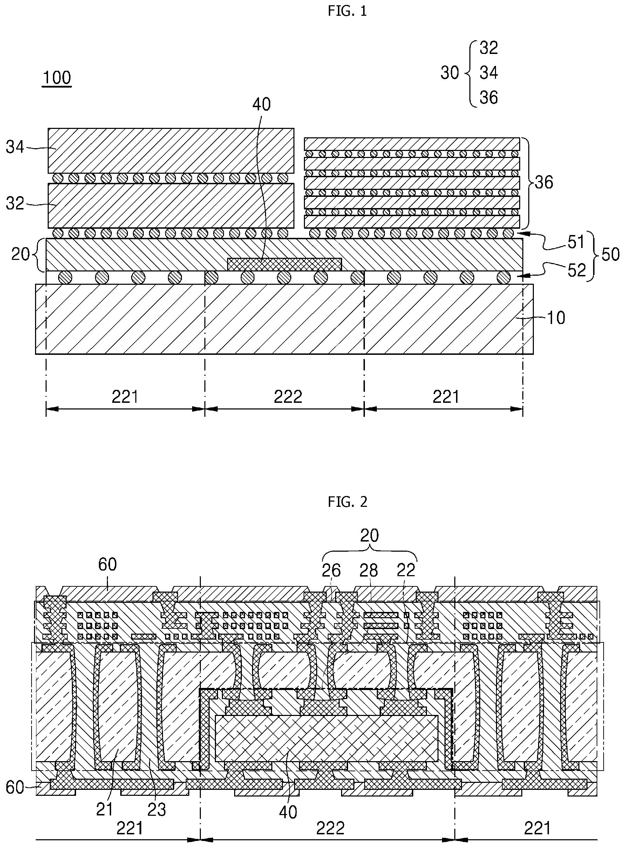

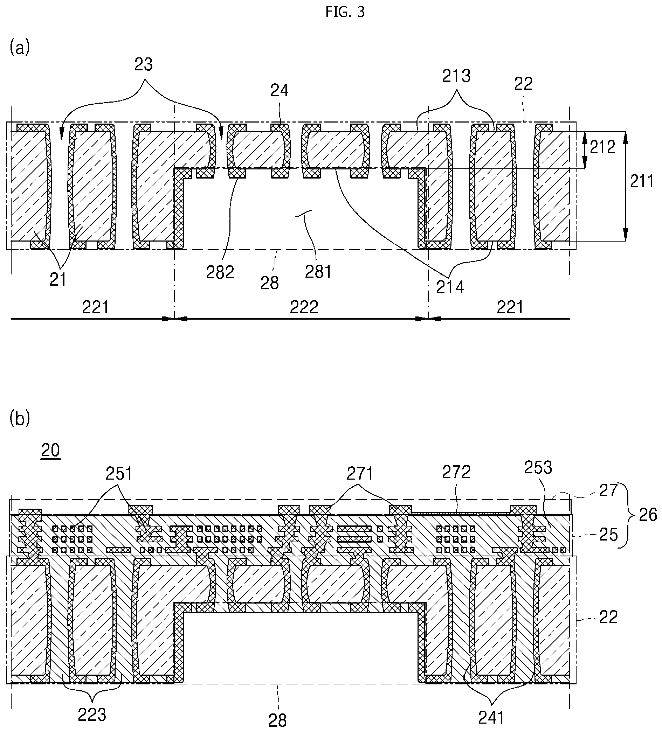

FIG. 1 is a conceptual diagram illustrating a cross-sectional structure of a packaging substrate according to an embodiment, FIG. 2 is a conceptual diagram illustrating a cross-sectional structure of a packaging substrate according to another embodiment, and FIG. 3A and FIG. 3B are conceptual diagrams illustrating cross-sections of portions of a packaging substrate according to embodiments, respectively.

A semiconductor device 100 according to the embodiment includes a semiconductor element portion 30 on which one or more semiconductor elements 32, 34, 36 are located; a packaging substrate 20 electrically connected to the semiconductor devices; and a motherboard 10 electrically connected to the packaging substrate 20 and transmitting external electrical signals to the semiconductor elements 32, 34, 36 with each other.

The packaging substrate 20, according to the embodiment, includes a core layer 22, an upper layer 26 disposed on a side of the core layer 22, and a cavity portion 28 in which a semiconductor element 40 can be located.

The semiconductor element portion 30 refers to an element which is mounted on a semiconductor manufacture and is mounted on the packaging substrate 20 by means of a contact electrode or the like. Specifically, the semiconductor element portion 30 can be applied to, for example, a computing element (first element, 32, second element, 34) such as a CPU or GPU, a memory device (third element, 36) such as a memory chip, etc.

The motherboard 10 may be a board such as a printed circuit board, a printed wiring board, or the like.

The packaging substrate 20 may optionally further include a lower layer (not shown) disposed under the core layer.

The core layer 22 may include a glass core 21, which includes a first zone 221 having a first thickness 211 and a second zone 222 adjacent to the first zone 221 and having a second thickness 212 that is thinner than the first thickness 211 above, a plurality of core vias 23 penetrating the glass core 21 in the thickness direction and a core distribution layer 24 that is located on the surface of the glass core 21 or the core via 23 and electrically connects the first face 213 of the glass core 21 and the second face 214 facing the first face through the core via 23.

The second zone 222 of the core layer 22 may serve as a cavity structure.

Within the same zone, the glass core 21 has a first face 213 and a second face 214 that face each other, and these two surfaces are substantially parallel to each other and have a constant thickness throughout the glass core 21.

The inner space 281 formed by the difference in thickness of the first zone 221 and the second zone 222 serves to accommodate some or all the semiconductor elements 40.

The glass core 21 may include core vias 23 connecting the first face 213 and the second face 214. The core vias 23 may be formed in both the first zone 221 and the second zone 222 and may be formed in any desired pitch and pattern.

As a packaging substrate for semiconductor devices, silicon substrates and organic substrates have traditionally been applied in a laminated form. In the case of silicon substrates, due to the nature of semiconductors, parasitic devices may occur when applied to high-speed circuits, and power losses are relatively high. In addition, organic substrates require a large area to form more complex distribution patterns, which is not suitable for the trend of miniaturization of electronic devices. In order to form a complex distribution pattern within a certain size, pattern refinement is practically necessary, but there were practical limitations in pattern refinement due to the characteristics of materials such as polymers applied to organic substrates.

In the present disclosure, the glass core 21 is applied as a support for the core layer 22 as a way to solve these problems. In addition, a core via 23 formed through the glass core 21 is also applied in conjunction with the glass core 21 to provide a packaging substrate 20 having shorter electrical flow lengths, more miniaturized, faster response, and lower signal loss characteristics.

The glass core 21 may preferably be a glass substrate applied to a semiconductor, for example, a borosilicate glass substrate, an alkali-free glass substrate, and the like, but is not limited thereto.

The core via 23 penetrates the glass core 21. The core via 23 may be formed by removing a predetermined area of the glass core 21, in particular by etching the glass core by physical and/or chemical means.

Specifically, the formation of the core via 23 may be accomplished by forming defects (inclusions) on the surface of the glass core, such as by laser ablation or the like, followed by chemical etching, laser etching, and the like, but is not limited to these methods.

The core vias 23 may be 100 to 3000 in number, 100 to 2500 in number, or 225 to 1024 in number based on a unit area (1 cm x 1 cm) of the glass core 21. If these pitch conditions are satisfied, the formation of an electrically conductive layer or the like and the performance of the packaging substrate may be improved.

The core distribution layer 24 includes a core distribution pattern 241, which is an electrically conductive layer electrically connecting the first and second faces of the glass core in through the core vias, and a core insulating layer 223 surrounding the core distribution pattern. The core layer 22 has an electrically conductive layer formed therein core vias. The electrically conductive layer may serve as an electrical pathway across the glass core 21. Furthermore, the core layer 22 may connect the upper and lower parts of the glass core over a relatively short distance, resulting in faster electrical signal transmission and low signal loss. The electrically conductive layers may be, for example, but not limited to, copper plated layers.

The cavity portion 28 is substantially circular, triangular, square, hexagonal, octagonal, cross-shaped, or otherwise any other desired shape.

The semiconductor element 40 may be generally cylindrical, cuboidal, or polygonal in shape.

The cavity portion 28 may include a cavity distribution pattern, which is an electrically conductive layer electrically connecting the semiconductor element 40 and the core distribution layer 24, and an insulating layer surrounding the cavity distribution pattern.

Alternatively, the cavity part according to another embodiment may be implemented in a form that penetrates the first face 213 and the second face 214 of the glass core 21. In this case, the cavity part may be formed according to the same process as the formation process of the core vias 23 and may differ from the core vias 23 in terms of the area and shape through the glass core 21.

In such an implementation, after the semiconductor element 40 is arranged in the cavity part, an insulating layer may be formed. That is, the insulating layer may also be formed in the cavity part through the process of forming the core insulating layer 223 described above.

The core distribution pattern 241 may be patterned to be electrically coupled to the semiconductor element 40.

The semiconductor element 40 may include an active element, such as a transistor, or a passive element, such as a power transfer element, such as a multilayer ceramic capacitor (MLCC).

An element such as a transistor that plays a role in converting electrical signals between the motherboard and the semiconductor device part appropriately may be applied to the semiconductor element 40. In such a case, a transistor or the like may be applied in the vicinity of the packaging substrate 20, thereby providing a semiconductor device 100 having a more efficient and faster speed.

In addition, power transfer elements such as multilayer ceramic capacitors (MLCCs) play a critical role in the performance of semiconductor devices. As passive devices, it is common to have at least 200 power transfer elements in a semiconductor device. In transferring power, the characteristics of the electrically conductive layer around the device can affect the performance of the device. In one embodiment, non-circular shaped core vias can be applied where a low resistance electrically conductive layer is required, such as in power transfer devices.

In addition, the semiconductor element 40 may be applied by inserting passive elements such as capacitors individually. Alternatively, a plurality of passive elements may be embedded within the insulator layer (semiconductor element insulating layer) to form a group of elements. The group of elements may be inserted into the semiconductor element 40 after electrodes of the group of elements is exposed. The latter option may be more workable for packaging substrate fabrication and more advantageous for ensuring that the insulating layer is sufficiently and reliably located in the space between the complex elements.

The glass core 21 plays an intermediary role, an intermediary role, connecting the semiconductor element portion 30 on the upper side of the glass core 21 and the motherboard 10 lower side of the glass core 21, respectively, and the core via 23 acts as a passageway for transmitting electrical signals therebetween, thereby facilitating smooth signal transmission. For the purpose of distinguishing from the core via of the second zone 222 described later, the core via disposed in the first zone 221 will be referred to as the first zone core via 231.

An upper layer 26 may be on the first face 213.

The upper layer 26 may include an upper distribution layer 25 and a top surface contact layer 27 located above the upper distribution layer 25, and the uppermost surface of the upper layer 26 may be protected by a cover layer 60 having an opening formed through which the contact electrodes of the semiconductor device part can directly contact.

The upper distribution layer 25 may include an upper insulating layer 253 disposed on the first face; and an upper distribution pattern 251 embedded in the upper insulating layer 253 as an electrically conductive layer having a predetermined pattern and electrically connecting at least a portion thereof with the core distribution layer 24. The upper distribution layer 25 disposed above and the upper distribution layer 25 below may be connected to each other through blind via.

The upper insulating layer 253 may be applied as an insulator layer to a semiconductor device or packaging substrate, and may be, for example, an epoxy-based resin containing fillers, but is not limited thereto.

The insulator layer may be formed by forming a coating layer and curing it, or it may be formed by laminating an uncured or semi-cured insulator film on the core layer 22 and curing it. **In** this case, by applying a reduced-pressure lamination method or the like, the insulator can be embedded into the space inside the core vias 23, and the process can proceed efficiently.

**In** some embodiments, the plurality of insulating layers may be stacked and substantially indistinguishable from one another, and the plurality of insulating layers is collectively referred to as the upper insulating layer. Additionally, the core insulating layer 223 and the upper insulating layer 253 may be made of the same insulating material, in which case the boundary between them may be substantially indistinguishable. Alternatively, in other embodiments, the boundaries of the insulator layers may be formed by setting different pressures and temperatures to cure the multiple insulator layers.

The upper distribution pattern 251 refers to an electrically conductive layer located within the upper insulating layer 253 in a preset shape, and may be formed, for example, using a build-up layer method. Specifically, the electrically conductive layer may be formed by forming an insulator layer, removing unnecessary portions of the insulator layer, and then copper-plating or the like. Then, after optionally removing an unnecessary portion of the electrically conductive layer, an insulator layer may be formed on top of the electrically conductive layer, and the method of forming the electrically conductive layer by removing the unnecessary portion and plating or the like may be repeated. In this way, the upper distribution pattern 251 may be formed in which the electrically conductive layer is formed in a vertical or horizontal direction depending on the intended pattern.

Since the upper distribution pattern 251 is located between the core layer 22 and the semiconductor element portion 30, it may be formed to include a micropattern in at least a portion thereof so that the transmission of electrical signals to the semiconductor element portion 30 may proceed smoothly and the intended complex pattern may be sufficiently accommodated. In this case, the micropattern may have a width and spacing of 4 µm or less, 3.5 µm or less, 3 µm or less, 2.5 µm or less, 1 to 2.3 µm, or the like (hereinafter, the description of the micropattern will be the same).

The top surface contact layer 27 may include a top surface connection pattern 272 electrically connected, at least partially, with the upper distribution pattern 251 and located on the upper insulating layer 253, and a top surface contact electrode 271 electrically connecting between the top surface connection pattern 272 and the semiconductor element portion 30.

The top surface connection pattern 272 may be located on a surface of the upper insulating layer 253, or at least a portion thereof may be exposed and the remainder may be embedded within the upper insulating layer. For example, if the top surface connection pattern is located on one surface of the upper insulating layer, the upper insulating layer may be formed by plating or the like. In addition, the top surface connection pattern having a part thereof exposed and the remainder embedded within the upper insulating layer may be one made by removing a part of an insulating layer or an electrically conductive layer by surface polishing, surface etching, or the like after forming a copper plating layer or the like.

The top surface connection pattern 272 may include at least a portion of a micropattern, similar to the upper distribution pattern 251 described above. The top surface connection pattern 272 including such micropatterns may enable a larger number of devices to be electrically connected in a smaller area, allowing for smoother electrical signal connections between devices or to the outside, and enabling more integrated packaging.

The top surface contact electrode 271 may be directly connected to the semiconductor element portion 30 by terminals or the like or may be connected via an electrical connection portion 51 such as a solder ball.

The cavity portion 28 may include a cavity distribution layer 282 located above and/or below the second zone 222 and electrically connected to the core distribution pattern 241, and an inner space 281 where the semiconductor element 40 are located. The cavity distribution layer 282 may be formed through the second zone core via 232.

Specifically, the second zone 222 has a thinner thickness of the glass core 21 compared to the first zone 221, and the semiconductor element 40 may be located in the inner space 281 formed due to the difference in thickness between the first zone 221 and the second zone 222. Furthermore, the core vias 23 and the core distribution layer 24 formed in the glass core 21 may serve as an electrical connection structure connecting the semiconductor element 40 to the external element.

Furthermore, as described above, in the first zone 221, a cavity part in the form of passing through, the first face 213 and the second face 214 of the glass core 21 may be formed, and the semiconductor element 40 may be arranged within the cavity part.

The packaging substrate 20 may be also connected to a motherboard 10. The motherboard 10 may be electrically connected to the core distribution pattern 241 located on at least a portion of the second face 214 of the core layer 22 by terminals of the motherboard 10, either directly or via a board connection portion 52 such as a solder ball. In addition, the core distribution pattern 241 in contact with the motherboard 10 may be connected to the motherboard 10 via a lower layer (not shown) located below the core layer 22. The electrical connection portion 51 and the board connection portion 52 are collectively referred to as the connection portion 50.

In one embodiment, no substantially additional substrate other than the glass core 21 may be applied to the packaging substrate 20 positioned between the semiconductor element portion 30 and the motherboard 10.

Traditionally, the interposer and organic substrate are laminated together between the device and the motherboard. There are at least two reasons for this multi-step application: one is that there are scale issues with directly bonding the fine pattern of the device to the motherboard, and the other is that wiring damage may occur during the bonding process or during the driving process of the semiconductor device due to difference in thermal expansion coefficient between the device and the motherboard.

In the present disclosure, this problem may be solved by applying a glass core with a coefficient of thermal expansion similar to that of a semiconductor device and forming a micropattern on the first face of the glass core and the upper layer with a scale fine enough for device mounting.

In the following, a method for manufacturing a packaging substrate according to the present disclosure will be described.

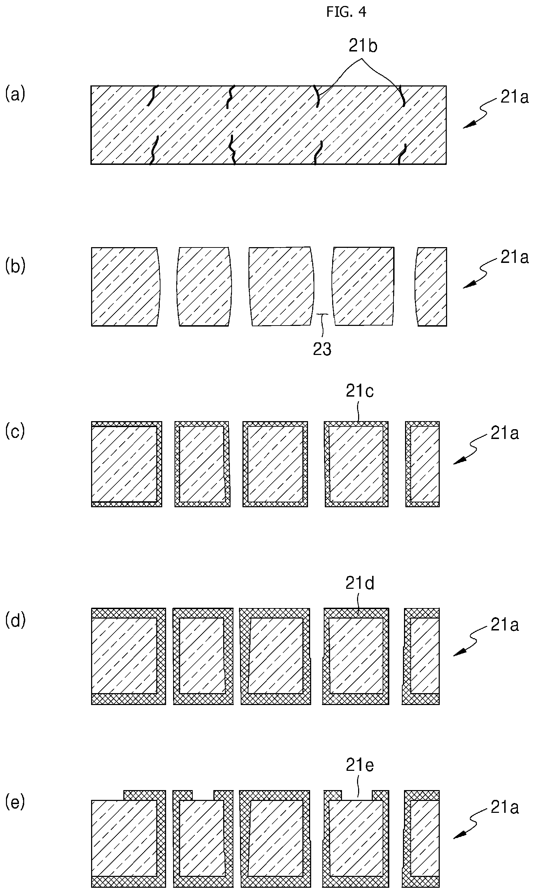

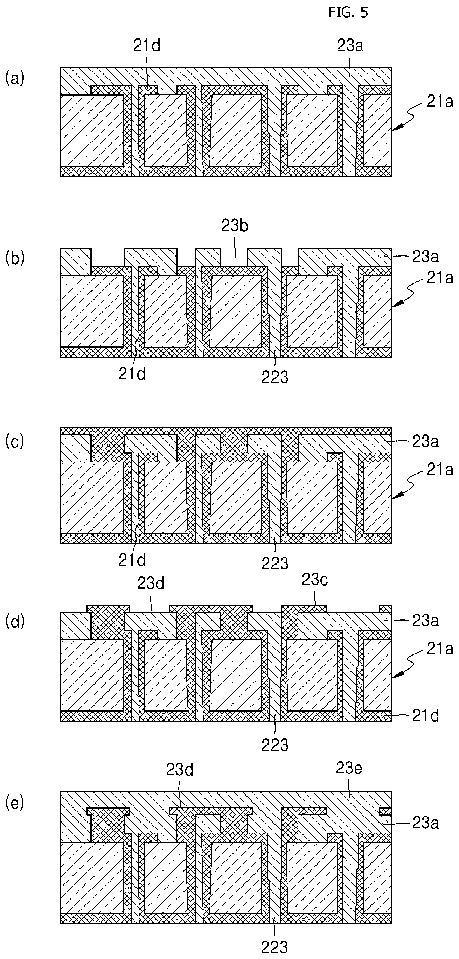

FIG. 4 and FIG. 5 are flowcharts illustrating a cross-sectional view of the manufacturing process of a packaging substrate according to the present disclosure.

First, as shown in FIG. 4A, a glass core 21a having a first surface and a second face may be prepared, and a defect (groove, 21b) may be formed on the glass surface at a predetermined position for forming a core via. The glass core may be a glass core commonly applied to a substrate of an electronic device or the like, and for example, an alkali-free glass core may be applied, but is not limited thereto. Commercially available products manufactured by manufacturers such as Corning, Schott, AGC, and the like may be applied. The defects (grooves) may be formed by mechanical etching, laser irradiation, or the like.

As shown in FIG. 4B, the glass core 21a in which the defect (groove, 21b) is formed may be subjected to an etching step to form a core via 23 through a physical or chemical etching process. During the etching process, the glass core forms vias in the defect portion and at the same time, the surface of the glass core 21a may be etched. A masking film or the like may be applied to prevent such etching of the glass surface, but the defective glass core without the masking film may be etched in consideration of cumbersomeness of the process of applying and removing the masking film, and in such a case, the thickness of the glass core having the core via may be somewhat thinner than the thickness of the initial glass core.

Then, the core layer manufacturing step may be performed by forming an electrically conductive layer 21d on the glass core as shown in FIG. 4C and FIG. 4D. The electrically conductive layer may be a metal layer including, but not limited to, copper metal.

The surface of the glass (including the surface of the glass core and the surface of the core via) and the surface of the copper metal may have different properties each other, and the adhesion between them may be poor. In the present disclosure, the adhesion between the glass surface and the metal may be improved by two methods, a dry method and a wet method.

The dry method may be a method of applying sputtering, that is, metal sputtering, to form a seed layer 21c on the surface of the glass and the inner diameter of the core via. In the formation of the seed layer, metal which is different from copper such as titanium, chromium, nickel, and the like may be sputtered together with copper, and in this case, glass-to-metal adhesion may be improved by an anchor effect in which the surface morphology of the glass and the metal particles interact.

The wet method may be a primer treatment method in which a primer layer 21c is formed by pretreatment with a compound having functional groups such as amines. Depending on the degree of adhesion desired, pretreatment with a silane coupling agent may be followed by primer treatment with a compound or particle having an amine functional group. As mentioned above, the support substrate of the present disclosure may be required to have high quality sufficient to form a micropattern, which should be maintained after the primer treatment. Therefore, if such primer includes nanoparticles, it may be preferred that nanoparticles having an average diameter of 150 nm or less are applied. In addition, for example, the nanoparticles may have an amine functional group. The primer layer may be formed by applying a bonding force improver, for example, such as the CZ series manufactured from MEC.

The seed layer/primer layer 21c may optionally form the electrically conductive layer with or without removing the portion where the formation of the electrically conductive layer is unnecessary. Furthermore, the seed layer/primer layer 21c may be optionally treated in an activated or deactivated state for metal plating with or without removing the portion where the formation of the electrically conductive layer is necessary or unnecessary to proceed with the subsequent process. For example, the activation or deactivation treatment may be subjected to light irradiation treatment such as a laser of a certain wavelength, chemical treatment, or the like. The formation of the metal layer may include, but is not limited to, copper plating methods applied in the manufacture of semiconductor devices.

As shown in FIG. 4E, a portion of the core distribution layer may be removed if it is unnecessary, and after the seed layer is partially removed or inactivated, metal plating may be performed to form an electrically conductive layer in a predetermined pattern to form the etch layer 21e of the core distribution layer.

FIG. 5 illustrates manufacturing steps to form an insulating layer and an upper distribution pattern, according to one embodiment.

As shown in FIG. 5A, the core via may be subjected to an insulating layer formation step in which the void space is filled with an insulating layer after the formation of the core distribution layer, which is an electrically conductive layer. In this case, the insulating layer applied may be made in the form of a film, for example, by reduced-pressure lamination of the insulating layer in the form of a film. By performing such reduced-pressure lamination, the insulating layer can be sufficiently impregnated into the void space inside the core vias to form a core insulating layer without void formation.

FIG. 5B to FIG. 5E illustrate the upper layer manufacturing steps.

The step of manufacturing the upper layer is to form an upper distribution layer comprising an upper insulating layer and an upper distribution pattern on the core layer. The upper insulating layer may be formed by coating a resin composition forming the insulating layer 23a or by laminating an insulating film, and the simplest method is to laminate an insulating film. The lamination of the insulating film may be carried out by laminating the insulating film and curing it, in which case, by applying a reduced-pressure lamination method, the insulating resin may be sufficiently impregnated even to a layer in which an electrically conductive layer is not formed inside the core via. The upper insulating layer may be also applied in direct contact with the glass core, at least in part, and thus it may have sufficient adhesion. Specifically, the glass core and the upper insulating layer may be preferably characterized by an adhesion test value of 4B or more according to ASTM D3359.

The upper distribution pattern may be formed by repeating the process of forming the insulating layer 23a, forming the electrically conductive layer 23c in a predetermined pattern by etching the unnecessary parts to form the etching layer 23d of the electrically conductive layer. In the case of an electrically conductive layer that is formed adjacent to an insulating layer, the electrically conductive layer may be formed by forming a blind vias 23b on the insulating layer and then proceeding with a plating process. Dry etching methods such as laser etching, plasma etching, etc., or wet etching methods using a masking layer, and an etching solution may be applied to form the blind vias.

Then, although not shown, a top surface contact layer and a cover layer may be formed.

The top surface connection pattern and the top surface contact electrode may also be formed by a process similar to the formation of the upper distribution layer. Specifically, it may be formed by forming an etching layer of an insulating layer on the insulating layer 23e, forming an electrically conductive layer on it again, and then forming an etching layer of an electrically conductive layer, and so on. Alternatively, it may be applied by selectively forming only the electrically conductive layer without applying the method of etching. The cover layer may be formed such that an opening (not shown) is formed at a position corresponding to the top surface contact electrode so that the top surface contact electrode is exposed and can be directly connected to an electrical connection part or a terminal of the device.

Once the upper layer has been formed, the process of forming the lower layer may proceed by forming the bottom contact layer and the cover layer. The lower layer and/or the bottom contact layer, and optionally the cover layer (not shown), may be formed in a similar manner to the steps for forming the top surface contact layer and cover layer described above.

As described above, the core layer may include a glass core, wherein the glass core may be a glass substrate having a first surface and a second face facing each other. Further, as described above, the packaging substrate may include a distribution layer located above and/or below the core layer.

The packaging substrate may include an upper layer above the core layer, wherein the upper layer may include a plurality of distribution layers. Optionally, the packaging substrate may further include a lower layer positioned below the core layer and the lower layer comprises a plurality of distribution layers. The plurality of distribution layers may be two or more layers, three or more layers, four or more layers, five or more layers, or six or more layers. Further, the plurality of distribution layers may be 30 layers or less, 26 layers or less, 22 layers or less, 18 layers or less, or 15 layers or less. However, the total number of distribution layers disposed on the upper or lower layers is not limited.

The distribution layer may be formed by placing an insulating film on or under the core layer and curing it. Exemplarily, the insulating film may include inorganic particles and polymer resins such as Ajinomoto Build-up Film (ABF). Exemplarily, the distribution layer may be formed by placing an insulating material such as an insulating film and a conductive pattern patterned with copper or the like on or under the core layer.

The distribution layer may be arranged in a multi-layer stacked structure, depending on the design of the redistributed line (RDL). If the distribution layer is laminated without conductive patterns, the insulating layer of the first layer is treated as the distribution layer. Also, if the distribution layer is laminated with a conductive pattern, the conductive pattern (or metal layer) and the insulating layer laminated with the conductive pattern are treated as the distribution layer.

The packaging substrate often may contain multiple distribution layers. In this case, several heat treatments are performed to pre-cure the insulating film. During this process, warpage of the glass core may occur, or strong stresses may be concentrated in the core layer. The inventors focused on the difference in CTE (coefficient of thermal expansion) between the insulating film and the glass core as one of the reasons for this phenomenon.

To solve the problem of cracking or breaking the glass core and delamination of the core and distribution layers during manufacturing, the present disclosure presented below.

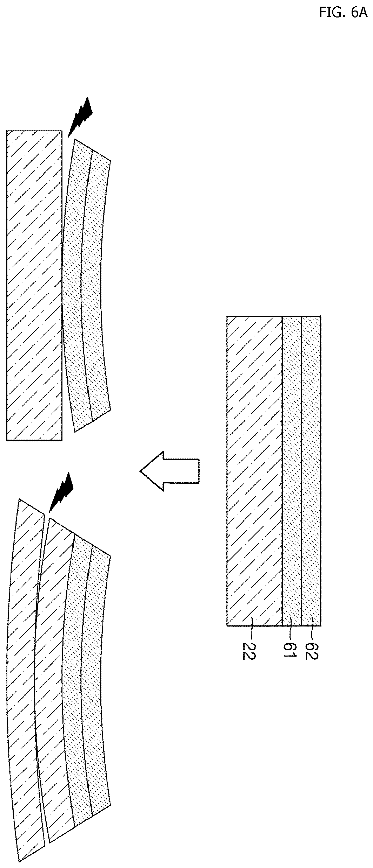

FIG. 6A through FIG. 6C are cross-sectional conceptual diagrams illustrating a problem encountered during heat treatment of a packaging substrate comprising a core layer and a plurality of distribution layers.

Referring to FIG. 6A, the packaging substrate may include a plurality of distribution layers disposed on the core layer. For example, the packaging substrate may include an upper layer disposed on the core layer and the upper layer may include a first distribution layer 61. The upper layer may include a first distribution layer 61 and a second distribution layer 62 disposed on the first distribution layer 61.

For example, the first distribution layer 61 may be formed by placing a first insulating material on the core layer and curing the first insulating material, and the second insulating material may be placed on the first distribution layer 61 and cured to form the second distribution layer 62.

Alternatively, for example, the first conductive pattern may be formed by forming an insulating layer by placing a first insulating material on the core layer, curing the insulating layer, removing the insulating layer of the portion to form the conductive pattern, and then plating a metal such as copper to fill the removed portion of the insulating layer. In this way, the first distribution layer 61 comprising the first insulating material and the first conductive pattern may be formed.

The second insulating material may be placed on the first distribution layer 61 and cured to form the second distribution layer 62. Alternatively, the second distribution layer 62 comprising a second insulating material and a second conductive pattern may be formed on the first distribution layer 61.

In manufacturing process of the first distribution layer 61 and the second distribution layer 62, several thermal processes may be performed. For example, the temperature of the substrate may be raised to approximately 60°C or more or 80°C or more, maintained, and lowered, and the processes may be repeated. In addition to the stress caused by the heat itself, various stresses are applied to the substrate, such as stress caused by the difference in CTE between the distribution layer and the core layer, and stress caused by the decrease in volume due to the induction of chemical bonding of the insulating material including a polymer resin or the like. For example, in the case of a glass core in which an amorphous glass plate is applied as a support, the core layer may be damaged, such as delamination of the boundary between the glass core and the upper layer or cracking of the glass core.

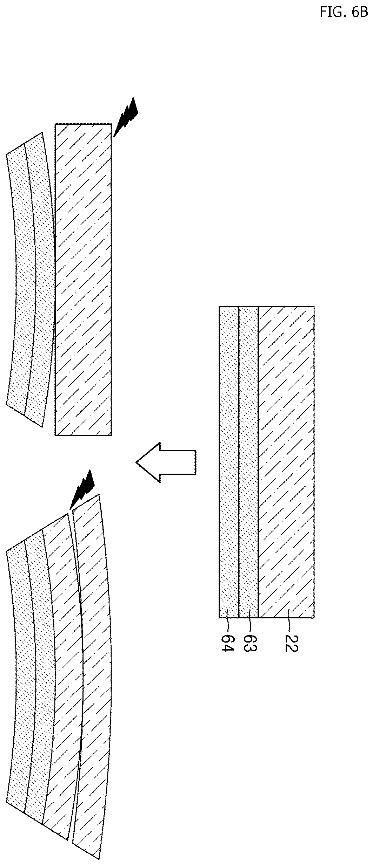

Also referring to FIG. 6B, the packaging substrate may include a plurality of distribution layers disposed under the core layer. For example, the packaging substrate may include a lower layer disposed under the core layer, wherein the lower layer may include a third distribution layer 63 and a fourth distribution layer 64. The third distribution layer 63 and the fourth distribution layer 64 may each include an insulating material, or an insulating material and a conductive pattern, just as the first distribution layer 61 and the second distribution layer 62 described above. As described above, the core layer may be damaged during the manufacturing of the lower layers.

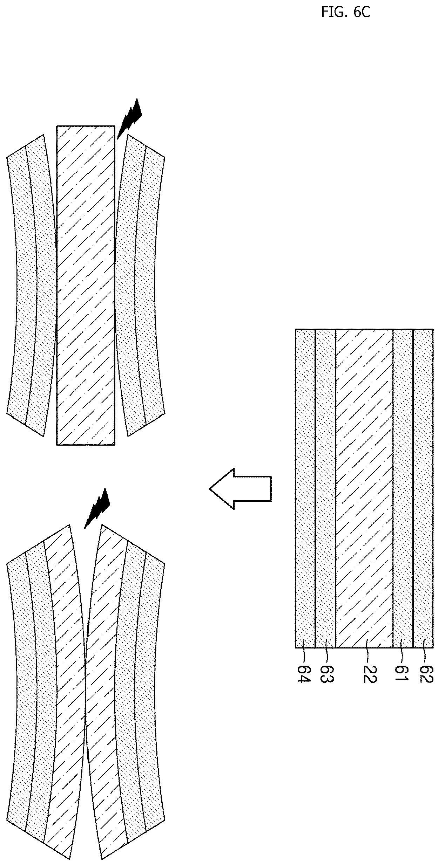

Also referring to FIG. 6C, the packaging substrate may include an upper layer disposed on the core layer and a lower layer disposed under the core layer, wherein the upper layer may include a first distribution layer 61 and a second distribution layer 62, and the lower layer may include a third distribution layer 63 and a fourth distribution layer 64. Each of the distribution layers may include an insulating material. Optionally, each distribution layer may include both an insulating material and a conductive pattern.

In the manufacturing process of each distribution layer, a multi-step process including heat treatment is involved, and in this process, various stresses may be applied to the core layer as described above, and even when the upper layer and the lower layer are simultaneously formed on both sides of the core layer, problems such as delamination of the boundary between the glass core and the upper layer or cracking of the glass core may occur.

Accordingly, the present disclosure proposes embodiments to solve the problem of warpage, stress, etc. caused by the difference in coefficient of thermal expansion (CTE) between the core layer and the distribution layer.

As an example, embodiments may be proposed in which a dummy layer is added to the upper layer and/or the lower layer to distribute the stresses that accumulate with changes in temperature. For example, the dummy layer may be a layer that shrinks to a lesser extent with changes in temperature compared to the first distribution layer or the third distribution layer.

The dummy layer may include a material having a lower CTE than the insulating material of the first distribution layer. Alternatively, the dummy layer may include a material having a lower CTE than the insulating material of the third distribution layer.

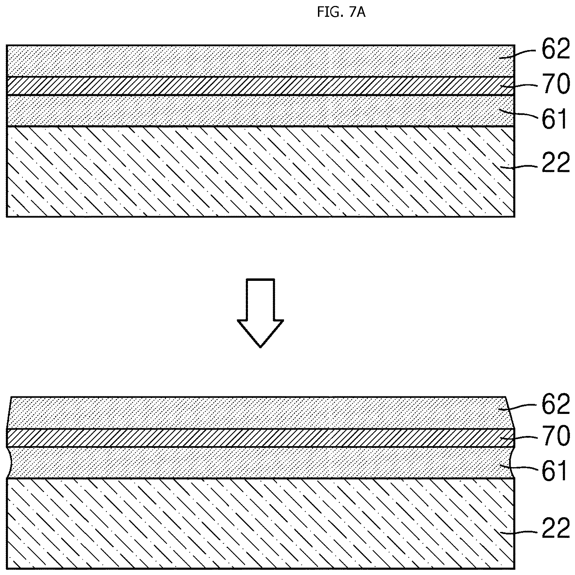

FIG. 7A through FIG. 7C are conceptual diagrams illustrating, in cross-section, a heat treatment process for a packaging substrate comprising a dummy layer formed between distributed layers, according to an embodiment. In one embodiment, the present disclosure proposes to form a dummy layer between the distribution layers and the dummy layer has a small degree of shrinkage with temperature change.

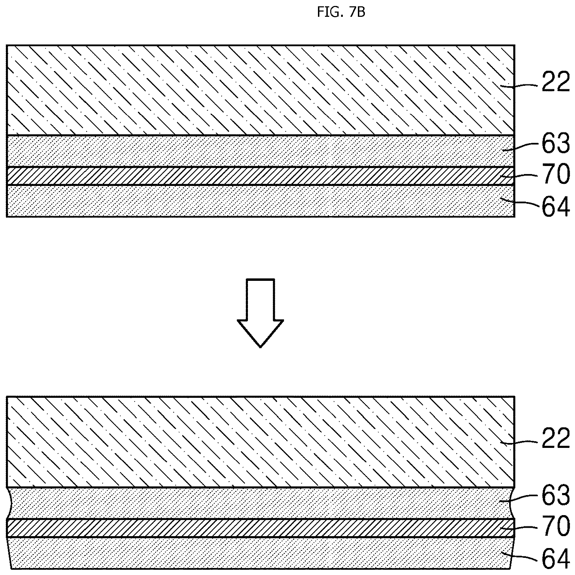

In one or more implementations, FIG. 7A and FIG. 7B illustrate a first distribution layer disposed directly on a surface of the core layer and a dummy layer disposed directly on a surface of the core layer, but additional layers (e.g., distribution layers) may be disposed between the core layer and the first distribution layer and/or between the first distribution layer and the dummy layer. In addition, an embodiment may have an additional layer (e.g., a distribution layer) disposed between the dummy layer and the second distribution layer; and/or on top of the second distribution layer.

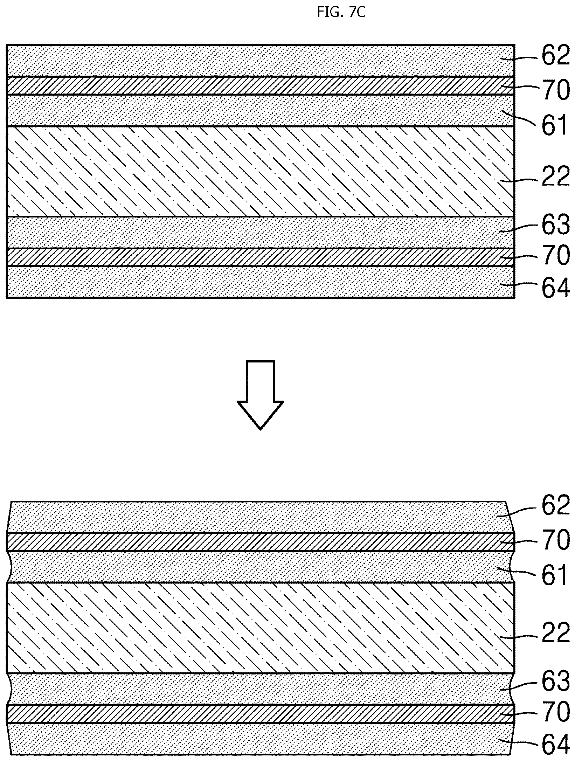

Further, in one or more embodiments, while FIG. 7B and FIG. 7C illustrate a third distribution layer disposed directly below the core layer and a dummy layer disposed directly below the third distribution layer, additional layers (e.g., distribution layers) may be disposed between the core layer and the third distribution layer; and/or between the third distribution layer and the dummy layer. In addition, an embodiment may have an additional layer (e.g., a distribution layer) disposed between the dummy layer and the fourth distribution layer; and/or under the fourth distribution layer.

Referring to FIG. 7A, a packaging substrate includes a core layer, and an upper layer disposed on the core layer. The core layer includes a glass core including first surface and second surface facing each other. Although not shown, the core layer may be arranged with core via, cavity, core insulating layer, core distribution pattern, and the like as shown in FIG. 1 and FIGs. 5A-5E. Also, although not shown, a cover layer, a contact electrode, and the like may be disposed above the upper layer and below the lower layer (the same as in the examples of FIG. 7B and FIG. 7C below).

The upper layer includes a first distribution layer 61 formed on the core layer, a dummy layer 70 formed on the first distribution layer 61, and a second distribution layer 62 formed on the dummy layer 70. The second distribution layer 62 may further include a fine distribution layer (not shown).

The fine distribution layer may be composed of electrically conductive patterns of a smaller thickness compared to the thickness of the electrically conductive patterns disposed in the second distribution layer 62.

Further, when inorganic particles are applied to the second distribution layer 62 and the fine distribution layer, respectively, the average size of the inorganic particle (inorganic particle B) in the fine distribution layer is different from the average size of the inorganic particle (inorganic particle A) in the second distribution layer 62. In particular, the average size of the inorganic particle A may be smaller than the average size of the inorganic particle B. In this case, it may be more advantageous to arrange a finer distribution pattern.

The dummy layer 70 may be disposed between the first distribution layer 61 and the second distribution layer 62 and may be in direct contact with the first distribution layer 61.

The dummy layer 70 may include a material having a lower CTE than the insulating material in the first distribution layer 61.

The dummy layer 70 includes M a material having a lower CTE than the insulating material in the first distribution layer 61 and the insulating material in the second distribution layer 62.

The CTE of the dummy layer 70 may be lower compared to the CTE of the first insulating material of the first distribution layer.

When the difference (absolute value) between the CTE of the glass core and the CTE of the first distribution layer is called D_C, and the difference (absolute value) between the CTE of the first distribution layer and the CTE of the dummy layer is called D_D, the D_D may be a value less than the D_C.

The dummy layer may substantially suppress damage caused by stress on the core layer in the manufacturing process of the packaging substrate, such as heat treatment, and in the operation process of a device mounted on the packaging substrate that involves heat generation.

The dummy layer may have a CTE of 20 ppm/°C or less. The CTE of the dummy layer may be 20 ppm/°C or less, 18 ppm/°C or less, 16 ppm/°C or less, 14 ppm/°C or less, 12 ppm/°C or less, or 10 ppm/°C or less. The CTE of the dummy layer may be greater than or equal to 3 ppm/°C, greater than or equal to 5 ppm/°C, or greater than or equal to 8 ppm/°C.

The thickness of the dummy layer 70 may be less than the thickness of the first distribution layer.

The difference between the thickness of the dummy layer 70 and the thickness of the first distribution layer may be 5 µm or more, 7 µm or more, 10 µm or more, 13 µm or more, or 15 µm or more. The difference may be 20 µm or less, or 17 µm or less.

The inorganic material content of the dummy layer 70 may be greater than or equal to 80 wt%, greater than or equal to 85 wt%, greater than or equal to 90 wt%, greater than or equal to 95 wt%, greater than or equal to 97 wt%, or greater than or equal to 99 wt%. The inorganic material content of the dummy layer may be less than or equal to 100 wt%.

The dummy layer 70 may include an inorganic layer.

The dummy layer 70 may be an inorganic layer.

The inorganic layer may include polycrystalline silicon, SiO2, and/or a metal layer.

The inorganic layer may include polycrystalline silicon, SiO2, and/or a metal layer.

The metal layer may be a metal plating layer. The metal layer may include copper. A metal layer comprising copper may be applied as the dummy layer.

Where the dummy layer includes a layer having electrically conductive properties, the layer is characterized in that it is not connected to the electrically conductive layer and an electrode (electrode in a through via) of the distribution layer.

For example, a first distribution layer 61 may be formed on the core layer, a dummy layer 70 may be formed on the first distribution layer 61, and a second distribution layer 62 may be formed on the dummy layer 70. The process of forming the first distribution layer 61 and the second distribution layer 62 is redundant to that described above, and therefore will not be described in detail.

As in the present disclosure shown in FIG. 7A, when a dummy layer 70 is formed between the distribution layers, the degree of shrinkage/expansion of the distribution layers located between the dummy layer 70 and the core layer may be mitigated during the manufacturing of the packaging substrate or the driving process thereof, due to the dummy layer 70 having a negligible degree of shrinkage with temperature change even when multiple thermal processes are performed.

Exemplarily, as shown in FIG. 7A, the occurrence of cure shrinkage after curing of the first distribution layer may stress the glass cores disposed in close proximity. In present disclosure, cracking and breakage of the core layer may be prevented by placing a dummy layer whose shrinkage is less than the shrinkage of the first distribution layer and whose volume changes less with temperature changes, thereby distributing the stress on the core layer caused by the cure shrinkage of the first distribution layer.

In other words, the embodiment may achieve the effect of distributing the stress concentrated in the core layer. This can have the effect of preventing delamination between the distribution layer and the core layer or cracking and breakage of the core layer due to warping of the distribution layer.

Optionally, if a metal layer with high thermal conductivity is applied to the dummy layer 70, the effect of dissipating heat generated by the packaging substrate may also be achieved.

On the other hand, the position of the dummy layer 70 may be arranged to face the glass core with the first distribution layer between them.

Exemplarily, the dummy layer 70 may be disposed to face to the front surface of the glass core. Exemplarily, the dummy layer 70 may be disposed in an area excluding an edge portion of the glass core (not shown), i.e., the dummy layer 70 may be disposed to correspond to a smaller area than the front of the glass core. Exemplarily, the dummy layer 70 may be disposed in an area excluding the dummy area (not shown). When the core layer (or packaging substrate) is viewed from above, a plurality of unit packaging substrates may be disposed. The dummy region refers to an area on the core layer excluding the portion where the unit packaging substrates are disposed.

As shown in FIG. 7A, the dummy layer may have one layer disposed on the upper layer. Alternatively, the dummy layer may have two or more layers disposed on the upper layer as desired. The number of applications or coverage of the dummy layer may be adjusted to any possible position.

Alternatively, and referring to FIG. 7B, the packaging substrate may include a core layer, and a lower layer disposed under the core layer. A detailed description of the core layer and the like is redundant to the description given above, and therefore will be omitted.

The lower layer may include a third distribution layer 63 formed under the core layer, a dummy layer 70 formed under the third distribution layer 63, and a fourth distribution layer 64 formed under the dummy layer 70.

The dummy layer 70 may be located between the third distribution layer 63 and the fourth distribution layer 64 and may be in direct contact with the third distribution layer 63.

The dummy layer 70 may include a material having a lower CTE than the insulating material in the third distribution layer 63.

The CTE of the dummy layer 70 may be smaller compared to the CTE of the third insulating material of the third distribution layer.

When the difference (absolute value) between the CTE of the glass core and the CTE of the third distribution layer is called D_C, and the difference (absolute value) between the CTE of the third distribution layer and the CTE of the dummy layer is called D_D, the D_D may be a value less than the D_C.

The specific description of the dummy layer is redundant to the description above, so we omit the detailed description.

For example, a third distribution layer 63 may be placed under the core layer and cured. Subsequently, a dummy layer 70 may be formed under the third distribution layer 63, and a fourth distribution layer 64 may be placed and cured under the dummy layer 70.

For example, a third distribution layer 63 may be formed under the core layer, a dummy layer 70 may be formed under the third distribution layer 63, and a fourth distribution layer 64 may be formed under the dummy layer 70. The process of forming the third distribution layer 63 and the fourth distribution layer 64 is redundant to that described above and will not be described in detail.

If a dummy layer 70 is formed between the distribution layers, such as in the embodiment shown in FIG. 7B, damage to the core layer can be substantially suppressed. Optionally, if a metal layer with high thermal conductivity is applied to the dummy layer 70, the effect of dissipating heat generated by the packaging substrate can also be achieved.

In addition, the position of the dummy layer 70 may be arranged to face the glass core with the third distribution layer in between. The specific description of the area in which the dummy layer is disposed, lower layer having one or more layers, etc. will not be described in detail as it corresponds to the description of the dummy layer disposed in the upper layer above.

The thickness of the dummy layer 70 may be less than the thickness of the third distribution layer.

The difference between the thickness of the dummy layer 70 and the thickness of the third distribution layer may be 5 µm or more, 7 µm or more, 10 µm or more, 13 µm or more, or 15 µm or more. The difference may be 20 µm or less, or 17 µm or less.

The dummy layer 70 may include an inorganic layer. A description of the ingredients, composition, etc. of the dummy layer is redundant to the above description, and therefore will not be described in detail.

Alternatively, referring to FIG. 7C, the packaging substrate may include a core layer, an upper layer disposed on the core layer, and a lower layer disposed under the core layer. The core layer may include a glass core including a first surface and a second surface facing each other, the upper layer may include a first distribution layer 61 formed on the core layer, and a dummy layer 70 formed on the first distribution layer 61, a second distribution layer 62 formed on the dummy layer 70, and the lower layer may include a third distribution layer 63 formed below the core layer, a lower layer of dummy layers 70 formed below the third distribution layer 63, and a fourth distribution layer 64 formed below the lower layer of dummy layers 70. The second distribution layer 62 may further include a fine distribution layer (not shown). A detailed description of the fine distribution layer is redundant to the description given above and is therefore omitted.

The upper layer of the packaging substrate may include a dummy layer 70 positioned between the first distribution layer 61 and the second distribution layer 62, and the lower layer of the packaging substrate may include a dummy layer 70 positioned between the third distribution layer 63 and the fourth distribution layer 64.

The dummy layer 70 of the upper layer may be in direct contact with the first distribution layer 61, and the dummy layer 70 of the lower layer may be in direct contact with the third distribution layer 63. In such a case, the glass core and the dummy layer are arranged with the first distribution layer (or the third distribution layer) between the glass core and the dummy layer, which may alleviate the stress applied to the boundary of the glass core and the upper layer (or the lower layer) by the first distribution layer (or the third distribution layer) and may reduce the occurrence of defects in the packaging substrate.

The specific description of the dummy layer is as described above.

For example, the packaging substrate according to one embodiment may have, as an upper layer, a distribution layer A, a distribution layer B, a dummy layer 70, a distribution layer C, and a distribution layer D sequentially disposed on the core layer 22, wherein the distribution layer B may be treated as a first distribution layer 61 and the distribution layer C may be treated as a second distribution layer 62. The distribution layer D may be a fine distribution layer. Further, the packaging substrate may have, as a lower layer, a distribution layer E, a distribution layer F, a solder resist, and a bump layer disposed sequentially under the core layer 22.

For example, the packaging substrate according to one embodiment may have, as an upper layer, a distribution layer A, a dummy layer 70, a distribution layer B, and a distribution layer C sequentially disposed on the core layer 22, wherein the distribution layer A may be treated as a first distribution layer 61 and the distribution layer B may be treated as a second distribution layer 62. The distribution layer C may be a fine distribution layer. Further, the packaging substrate may have, as a lower layer, a distribution layer E, a distribution layer F, a solder resist, and a bump layer arranged in sequence under the core layer 22. The distribution layer E may be treated as a third distribution layer 63 and the distribution layer F may be treated as a fourth distribution layer 64.

For example, a packaging substrate according to one embodiment may have, as an upper layer, a distribution layer A, a dummy layer, a distribution layer B, and a distribution layer C sequentially disposed on the core layer 22, wherein the distribution layer A may be treated as a first distribution layer 61 and the distribution layer B may be treated as a second distribution layer 62. The distribution layer C may be a fine distribution layer. Furthermore, the packaging substrate may have, as a lower layer, a distribution layer E, a dummy layer 70, a distribution layer F, a solder resist, and a bump layer arranged in sequence under the core layer 22. The distribution layer E may be treated as the third distribution layer 63, and the distribution layer F may be treated as the fourth distribution layer 64.

The present disclosure also proposes manufacturing methods for packaging substrates according to embodiments. For example, a manufacturing method for a packaging substrate according to an embodiment of the present disclosure may include the following.

For example, a core layer 22 comprising a glass core 21 may be prepared. As described above, the core layer 22 may include the glass core 21 including a first surface and a second surface facing each other.

An insulating material may then be placed on the core layer 22 and cured to form a first distribution layer 61. The first distribution layer 61 may include an insulating material.

For example, the insulating material may be a polymer resin, a mixture of a polymer resin and a filler (inorganic particles, organic particles, organic-inorganic composite particles, etc.), or the like. For example, the polymer resin may be an acrylic resin, an epoxy resin, a modification thereof, or the like, and a material applicable for the purpose of molding an electronic device may be applied. For example, a liquid crystal polymer (LCP) or the like may be applied.

Exemplarily, the mixture may be a mixture of an acrylic resin and a filler, a mixture of an acrylic resin, an epoxy resin and a filler, a mixture of an epoxy resin and a filler, and the like. The filler may be an inorganic particle, exemplarily a silica particle. As commercially available products, Ajinomoto Build-up Film (ABF), Epoxy Molding Compound (EMC), and the like may be applied, but are not limited to.

In addition, when the first distribution layer 61 includes both the first insulating material and the first conductive pattern, a process in which a distribution layer is formed may be applied. For example, after the first insulating material is placed on the core layer 22 and cured, a portion of the first insulating material may be removed in consideration of the shape of the first conductive pattern, and the first conductive pattern may be formed by plating or the like to form the first distribution layer.

Next, a dummy layer 70 may be formed on top of the first distribution layer 61. For example, the dummy layer 70 may be applied with the material described above.

If the dummy layer is a metal layer, methods such as metal plating, metal deposition, etc. may be applied. If the dummy layer is an inorganic layer, methods such as sputtering, deposition, etc. may be applied.

Next, the insulating material may be placed on the dummy layer 70 and cured to form the second distribution layer 62. The process for manufacturing the second distribution layer may be similar to the process for manufacturing the first distribution layer above.

The CTE of the first insulating material and the CTE of the second insulating material are different. In this case, different materials refer to materials with different components or materials with the same components but different contents, resulting in different physical properties.

The method of manufacturing the packaging substrate may further include: disposing the third insulating material and third conductive pattern under the core layer to form a third distribution layer; forming a lower dummy layer under the third distribution layer; and disposing the fourth insulating material and fourth conductive pattern under the lower dummy layer to form a fourth distribution layer.

The manufacturing process of the third distribution layer, the dummy layer, and the fourth distribution layer corresponds to the manufacturing process of the first distribution layer, the dummy layer, and the second distribution layer described above, so the details will not be described.

In the method of manufacturing a packaging substrate, the upper layer may be manufactured in the order of a first distribution layer, a dummy layer, and a second distribution layer.

In the method of manufacturing a packaging substrate, the lower layer may be manufactured in the order of a third distribution layer, a dummy layer, and a fourth distribution layer.

In the manufacturing method of the above packaging substrate, the upper layer and the lower layer may be manufactured in the order of a first distribution layer, a third distribution layer, a dummy layer (a dummy layer of the upper layer and a dummy layer of the lower layer), a second distribution layer, and a fourth distribution layer.

The method of manufacturing a packaging substrate according to the embodiments described above, and the packaging substrate using the method, may include a dummy layer without cure shrinkage between the distribution layers, so that the cure shrinkage of the distribution layer located between the dummy layer and the core layer may be relieved, thereby achieving the effect of dispersing the stress concentrated in the core layer.

In addition, due to the dummy layer formed between the distribution layers, the effect of preventing delamination between the distribution layer and the core layer that may occur during the heat treatment process or cracking and breakage of the core layer due to warpage of the distribution layers may be obtained.

## Claims

1. A packaging substrate (20), comprising:
a core layer (22); and
an upper layer (26) disposed on the core layer (22),
wherein the core layer (22) comprises a glass core (21) comprising a first face (213) and a second face (214) facing each other,
wherein the upper layer (26) comprises:
a first distribution layer (61) formed on the core layer (22);
a dummy layer (70) formed on the first distribution layer (61); and
a second distribution layer (62) formed on the dummy layer (70),
wherein the dummy layer (70) comprises a material having a lower Coefficient of Thermal Expansion (CTE) than a CTE of an insulating material of the first distribution layer (61) and a CTE of an insulating material of the second distribution layer (62), and
**characterized in that**
the CTE of the insulating material of the first distribution layer (61) and the CTE of the insulating material of the second distribution layer (62) are different.

2. The packaging substrate (20) of claim 1, further comprising:
wherein the dummy layer (70) is disposed between the first distribution layer (61) and the second distribution layer (62) and is in direct contact with the first distribution layer (61).

3. The packaging substrate (20) of claim 1, wherein when a difference (absolute value) between a CTE of the glass core (21) and a CTE of the first distribution layer (61) is D_C, and a difference (absolute value) between the CTE of the first distribution layer (61) and a CTE of the dummy layer (70) is D_D, and the D_D is smaller than the D_C.

4. The packaging substrate (20) of claim 1, wherein the dummy layer (70) comprises 80 wt% or more of an inorganic material.

5. The packaging substrate (20) of claim 1, wherein a CTE of the dummy layer (70) is 20 ppm/°C or less.

6. The packaging substrate (20) of claim 1, wherein the upper layer (26) further comprises:
a fine distribution layer (61) formed on the second distribution layer (62),
wherein the second distribution layer (62) comprises a first polymer resin and a first inorganic particle A,
wherein the fine distribution layer comprises a second polymer resin B and a second inorganic particle B, and
wherein an average size of the first inorganic particle is smaller than an average size of the second inorganic particle.

7. A method of manufacturing a packaging substrate (20), the method comprising:
preparing a core layer (22) comprising a glass core (21);
forming a first distribution layer (61) by disposing a first insulating material, a first conductive pattern, or a combination thereof on the core layer (22); and
forming a dummy layer (70) on the first distribution layer (61),
forming a second distribution layer (62) by disposing a second insulating material, a second conductive pattern, or a combination thereof on the dummy layer (70),
wherein the dummy layer (70) comprises a material having a lower CTE than a CTE of the first insulating material and a CTE of the second insulating material, and
wherein the CTE of the insulating material of the first distribution layer (61) and the CTE of the insulating material of the second distribution layer (62) are different.

8. The method of claim 7, further comprising forming a third distribution layer (63) by disposing a third insulating material and a third conductive pattern under the core layer (22),
wherein the dummy layer (70) comprises a material having a smaller CTE than a CTE of the third insulating material.

9. The method of claim 7, further comprising:
forming a third distribution layer (63) by disposing a third insulating material and a third conductive pattern under the core layer (22);
forming a lower dummy layer under the third distribution layer (63); and
forming a fourth distribution layer (64) by disposing a fourth insulating material and a fourth conductive pattern under the lower dummy layer.

## Patentansprüche

1. Verpackungssubstrat (20), umfassend:
eine Kernschicht (22); und
eine obere Schicht (26), die auf der Kernschicht (22) angeordnet ist,
wobei die Kernschicht (22) einen Glaskern (21) umfasst, der eine erste Fläche (213) und eine zweite Fläche (214) umfasst, die einander zugewandt sind,
wobei die obere Schicht (26) umfasst:
eine erste Verteilungsschicht (61), die auf der Kernschicht (22) ausgebildet ist;
eine Blindschicht (70), die auf der ersten Verteilungsschicht (61) ausgebildet ist; und
eine zweite Verteilungsschicht (62), die auf der Blindschicht (70) ausgebildet ist,
wobei die Blindschicht (70) ein Material umfasst, das einen niedrigeren Wärmeausdehnungskoeffizienten (CTE) als ein CTE eines Isoliermaterials der ersten Verteilungsschicht (61) und ein CTE eines Isoliermaterials der zweiten Verteilungsschicht (62) aufweist, und
**dadurch gekennzeichnet, dass**
der CTE des Isoliermaterials der ersten Verteilungsschicht (61) und der CTE des Isoliermaterials der zweiten Verteilungsschicht (62) unterschiedlich sind.

2. Verpackungssubstrat (20) nach Anspruch 1, ferner umfassend:
wobei die Blindschicht (70) zwischen der ersten Verteilungsschicht (61) und der zweiten Verteilungsschicht (62) angeordnet ist und in direktem Kontakt mit der ersten Verteilungsschicht (61) steht.

3. Verpackungssubstrat (20) nach Anspruch 1, wobei, wenn eine Differenz (absoluter Wert) zwischen einem CTE des Glaskerns (21) und einem CTE der ersten Verteilungsschicht (61) D_C ist, und eine Differenz (absoluter Wert) zwischen dem CTE der ersten Verteilungsschicht (61) und einem CTE der Blindschicht (70) D_D ist, und das D_D kleiner als das D_C ist.

4. Verpackungssubstrat (20) nach Anspruch 1, wobei die Blindschicht (70) 80 Gew.- % oder mehr eines anorganischen Materials umfasst.

5. Verpackungssubstrat (20) nach Anspruch 1, wobei ein CTE der Blindschicht (70) 20 ppm/C oder weniger ist.

6. Verpackungssubstrat (20) nach Anspruch 1, wobei die obere Schicht (26) ferner umfasst:
eine feine Verteilungsschicht (61), die auf der zweiten Verteilungsschicht (62) ausgebildet ist,
wobei die zweite Verteilungsschicht (62) ein erstes Polymerharz und ein erstes anorganisches Teilchen A umfasst,
wobei die feine Verteilungsschicht ein zweites Polymerharz B und ein zweites anorganisches Teilchen B umfasst, und
wobei eine durchschnittliche Größe des ersten anorganischen Teilchens kleiner als eine durchschnittliche Größe des zweiten anorganischen Teilchens ist.

7. Verfahren zum Herstellen eines Verpackungssubstrats (20), wobei das Verfahren umfasst:
Vorbereiten einer Kernschicht (22), die einen Glaskern (21) umfasst;
Ausbilden einer ersten Verteilungsschicht (61) durch Anordnen eines ersten Isoliermaterials, eines ersten leitfähigen Musters oder einer Kombination davon auf der Kernschicht (22); und
Ausbilden einer Blindschicht (70) auf der ersten Verteilungsschicht (61),
Ausbilden einer zweiten Verteilungsschicht (62) durch Anordnen eines zweiten Isoliermaterials, eines zweiten leitfähigen Musters oder einer Kombination davon auf der Blindschicht (70),
wobei die Blindschicht (70) ein Material umfasst, das einen niedrigeren CTE als ein CTE des ersten Isoliermaterials und ein CTE des zweiten Isoliermaterials aufweist, und
wobei der CTE des Isoliermaterials der ersten Verteilungsschicht (61) und der CTE des Isoliermaterials der zweiten Verteilungsschicht (62) unterschiedlich sind.

8. Verfahren nach Anspruch 7, ferner umfassend ein Ausbilden einer dritten Verteilungsschicht (63) durch Anordnen eines dritten Isoliermaterials und eines dritten leitfähigen Musters unter der Kernschicht (22),
wobei die Blindschicht (70) ein Material umfasst, das einen kleineren CTE als ein CTE des dritten Isoliermaterials aufweist.

9. Verfahren nach Anspruch 7, ferner umfassend:
Ausbilden einer dritten Verteilungsschicht (63) durch Anordnen eines dritten Isoliermaterials und eines dritten leitfähigen Musters unter der Kernschicht (22);
Ausbilden einer unteren Blindschicht unter der dritten Verteilungsschicht (63); und
Ausbilden einer vierten Verteilungsschicht (64) durch Anordnen eines vierten Isoliermaterials und eines vierten leitfähigen Musters unter der unteren Blindschicht.

## Revendications

1. Substrat d'encapsulation (20), comprenant :
une couche centrale (22) ; et
une couche supérieure (26) disposée sur la couche centrale (22),
où la couche centrale (22) comprend une âme en verre (21) comprenant une première face (213) et une deuxième face (214) opposées l'une à l'autre,
où la couche supérieure (26) comprend :
une première couche de distribution (61) formée sur la couche centrale (22) ;
une couche factice (70) formée sur la première couche de distribution (61) ;
et une deuxième couche de distribution (62) formée sur la couche factice (70),
où la couche factice (70) comprend un matériau ayant un coefficient de dilatation thermique (CTE) inférieur au CTE d'un matériau isolant de la première couche de distribution (61) et au CTE d'un matériau isolant de la deuxième couche de distribution (62),
**caractérisé en ce que** le CTE du matériau isolant de la première couche de distribution (61) et le CTE du matériau isolant de la deuxième couche de distribution (62) sont différents.

2. Substrat d'encapsulation (20) selon la revendication 1, où en outre :
la couche factice (70) est disposée entre la première couche de distribution (61) et la deuxième couche de distribution (62) et est en contact direct avec la première couche de distribution (61).

3. Substrat d'encapsulation (20) selon la revendication 1, où, si la différence (en valeur absolue) entre le CTE de l'âme en verre (21) et le CTE de la première couche de distribution (61) est D_C, et que la différence (en valeur absolue) entre le CTE de la première couche de distribution (61) et le CTE de la couche factice (70) est D_D, D_D est inférieur à D_C.

4. Substrat d'encapsulation (20) selon la revendication 1, où la couche factice (70) comprend au moins 80 % en poids d'un matériau inorganique.

5. Substrat d'encapsulation (20) selon la revendication 1, où le CTE de la couche factice (70) est égal ou inférieur à 20 ppm/°C.

6. Substrat d'encapsulation (20) selon la revendication 1, où la couche supérieure (26) comprend en outre :
une couche de distribution fine (61) formée sur la deuxième couche de distribution (62),
où la deuxième couche de distribution (62) comprend une première résine polymère et une première particule inorganique A,
où la couche de distribution fine comprend une deuxième résine polymère B et une deuxième particule inorganique B, et
où une la taille moyenne de la première particule inorganique est inférieure à la taille moyenne de la deuxième particule inorganique.

7. Procédé de fabrication d'un substrat d'encapsulation (20), ledit procédé comprenant :
la préparation d'une couche centrale (22) comprenant une âme en verre (21) ;
la formation d'une première couche de distribution (61) par disposition d'un premier matériau isolant, d'un premier motif conducteur ou d'une combinaison de ceux-ci sur la couche centrale (22) ; et
la formation d'une couche factice (70) sur la première couche de distribution (61),
la formation d'une deuxième couche de distribution (62) par disposition d'un deuxième matériau isolant, d'un deuxième motif conducteur ou d'une combinaison de ceux-ci sur la couche factice (70),
où la couche factice (70) comprend un matériau ayant un CTE inférieur au CTE du premier matériau isolant et au CTE du deuxième matériau isolant, et
où le CTE du matériau isolant de la première couche de distribution (61) et le CTE du matériau isolant de la deuxième couche de distribution (62) sont différents.

8. Procédé selon la revendication 7, comprenant en outre la formation d'une troisième couche de distribution (63) par disposition d'un troisième matériau isolant et d'un troisième motif conducteur sous la couche centrale (22),
où la couche factice (70) comprend un matériau ayant un CTE inférieur à celui du troisième matériau isolant.

9. Procédé selon la revendication 7, comprenant en outre :
la formation d'une troisième couche de distribution (63) par disposition d'un troisième matériau isolant et d'un troisième motif conducteur sous la couche centrale (22),
la formation d'une couche factice inférieure sous la troisième couche de distribution (63) ; et
la formation d'une quatrième couche de distribution (64) par disposition d'un quatrième matériau isolant et d'un quatrième motif conducteur sous la couche factice inférieure.
